# EUROPEAN PATENT APPLICATION

(11) **EP 0 869 555 A2**
(43) Date of publication of application: **07.10.1998**
(21) Application number: 98302405.0
(22) Date of filing: 30.03.1998
(51) Int. Cl.: H01L 23/52

(54) **Self-aligned contacts for semiconductor integrated circuits and method for producing the same**

(30) Priority: 01.04.1997 US 829053
(71) Applicant: SGS-THOMSON MICROELECTRONICS, INC., Carrollton Texas 75006-5039 (US)
(72) Inventor: Nguyen, Loi Ngoc, Carrollton, Texas 75007 (US)
(74) Representative: Palmer, Roger

(57) **Abstract**

A technique for forming a self-aligned contact in a semiconductor integrated circuit which improves the aspect ratio of the contact by reducing the thickness of the gate stack including the overgate dielectric and the local interconnect oxide layers and which provides a more planar device topography. The resultant contact structure also results in an improved isolation distance between the gate material contact and local polysilicon or polysilicide interconnect layers. The technique disclosed may be utilized in conjunction with the fabrication of memory device integrated circuits and other devices in both matrix and peripheral device elements without degradation of circuit performance.

## Description

The present invention relates, in general, to the field of semiconductor integrated circuit design and processing. More particularly, the present invention relates to a self-aligned contact for an integrated circuit device which improves gate to local interconnect isolation while simultaneously providing an increased contact area with a reduced contact aspect ratio.

Current integrated circuit semiconductor processing technology relies on the use of a silicon dioxide (SiO₂) or silicon nitride (Si₃N₄) dielectric layer overlying the gate of an active device such as a metal oxide semiconductor ("MOS") transistor. Such "overgate" layers are also generally utilized in conjunction with an SiO₂ or Si₃N₄ spacer layer adjoining the sides of the polysilicon or polysilicide gate material and overgate layers particularly in high density dynamic random access memory ("DRAM") and static random access memory ("SRAM") devices.

This overgate layer, whether SiO₂ or Si₃N₄, is then utilized in subsequent processing steps to form a self-aligned contact for the local interconnect in the memory cell. The thicker the dielectric overgate layer can be made, the better the isolation that is provided between the active device gate and the local interconnect layer. However, any increased thickness in the overgate layer translates into an increase in topographic disparities with an undesired concomitant decrease in device planarity in subsequent processing steps.

As integrated circuit devices geometries continue to shrink in order to provide denser memory and other integrated circuit devices, the aspect ratio of the contact becomes more severely constrained and the barrier metal available at the bottom of the contact hole becomes a critical limitation.

According to one aspect of the present invention there is provided an integrated circuit device formed on a semiconductor substrate having a major surface thereof, said device comprising at least one contact formed on a gate oxide layer overlying said major surface of said substrate, said contact comprising a doped semiconductor material formed to present at least one surface non-orthogonal to said substrate in a sidewall thereof, an insulating layer overlying said gate region, a spacer layer adjoining said insulating layer and substantially surrounding said contact sidewall and said non-orthogonal surface, and a local interconnect layer overlying said spacer layer and at least a portion of said insulating layer.

The contact may be substantially between 1500Å and 2000Å in thickness.

The insulating layer may comprise an overgate layer and an interpoly oxide layer.

The interpoly oxide layer may be substantially between 1000Å and 2000Å in thickness.

The overgate layer may be substantially between 1000Å and 2000Å in thickness.

The local interconnect layer may be substantially between 500Å and 2000Å in thickness.

According to another aspect of the present invention there is provided a process for forming an integrated circuit comprising the steps of providing a substrate, said substrate presenting a major surface thereof, forming a contact on a gate oxide layer overlying said major surface of said substrate, overlying said gate region with an insulating layer, etching said contact and said overgate layer to produce at least one surface in a sidewall of said contact non-orthogonal to said substrate, also forming at least one spacer layer adjoining said overgate layer and substantially surrounding said at least one non-orthogonal surface and said sidewall, and depositing a local interconnect layer overlying said spacer layer and at least a portion of said overgate layer.

The step of forming may be carried out by the step of depositing a doped semiconductor material of substantially between 1500Å to 2000Å in thickness.

The step of overlying may be carried out by the steps of firstly depositing an overgate layer on said contact; and secondly depositing an interpoly oxide layer at least partially overlying said overgate layer.

The step of secondly depositing may be carried out by the step of depositing Si0₂ to a thickness of substantially between 1000Å to 2000Å.

The step of depositing may be carried out by the step of depositing substantially between 500Å to 2000Å of a doped semiconductor material.

The doped semiconductor material may comprise Si0₂.

The doped semiconductor material may comprise Si₃N₄.

Disclosed herein is a technique for forming a self-aligned contact in a semiconductor integrated circuit which improves the aforementioned aspect ratio of the contact by reducing the thickness of the gate stack comprising the overgate dielectric and the local interconnect oxide layers resulting in a more planar device topography. The technique herein disclosed further allows for the formation of a self-aligned contact while also providing an improved isolation distance between the contact gate material and local interconnect layers. The technique of the present invention may be utilized in conjunction with the fabrication of memory device integrated circuits and other devices in both matrix and peripheral device elements without degradation of circuit performance.

Particularly disclosed herein is an integrated circuit device formed on a semiconductor substrate having a major surface thereof. The device includes at least one contact formed on an insulating layer, or gate oxide, overlying the major surface of the substrate. The contact may comprise a doped semiconductor material such as substantially between 1500Å to 2000Å of polysilicon or polysilicide (poly 1) formed by means of a two step isotropic and anisotropic etching steps to present at least one surface non-orthogonal to the substrate in at least one sidewall thereof. An insulating layer, which may comprise an overgate oxide layer of substantially between 1000Å to 2000Å of SiO₂ or Si₃N₄ and an interpoly oxide layer (also of substantially between 1000Å to 2000Å of SiO₂ or Si₃N₄) overlie the poly 1 contact. A spacer layer adjoins the insulating layer and substantially surrounds the contact sidewall and the non-orthogonal surface therein. A local interconnect layer also formed of a doped semiconductor material such as polysilicon or polysilicide (poly 2) overlies the spacer layer and at least a portion of the insulating layer and is formed to be substantially between 500Å to 2000Å in thickness.

The aforementioned and other features and objects of the present invention and the manner of attaining them will become more apparent and the invention itself will be best understood by reference to the following description of a preferred embodiment taken in conjunction with the accompanying drawings, wherein:
Figs. 1A through 1D are representative cross-sectional views of a prior art self-aligned contact processing sequence resulting in a gate to local interconnect spacing of on the order of near contact to substantially 400Å;
Figs. 2A through 2D are representative cross-sectional views of a self-aligned contact processing sequence in accordance with the present invention resulting in a gate to local interconnect spacing of on the order of 500Å to 1000Å; and
Fig. 3 is a top-plan view of a portion of an exemplary integrated circuit device cell layout manufactured in accordance with the process sequence of Figs. 2A through 2D.

With reference now to Figs. 1A through 1D a prior art self-aligned contact 10 process sequence is shown. With specific reference to Fig. 1A, the process begins with the provision of a suitable semiconductor substrate 12 upon which have been formed a relatively thin gate oxide layer 14 and a relatively thicker field oxide region 16. A gate 18 having substantially vertical sidewalls is then formed overlying the gate oxide layer 14. The gate 18 may be formed of polysilicon or polysilicide and is conveniently referred to as a "poly 1" layer. An overgate layer 20 of silicon dioxide (SiO₂) or silicon nitride (Si₃N₄) is then formed overlying the gate 18.

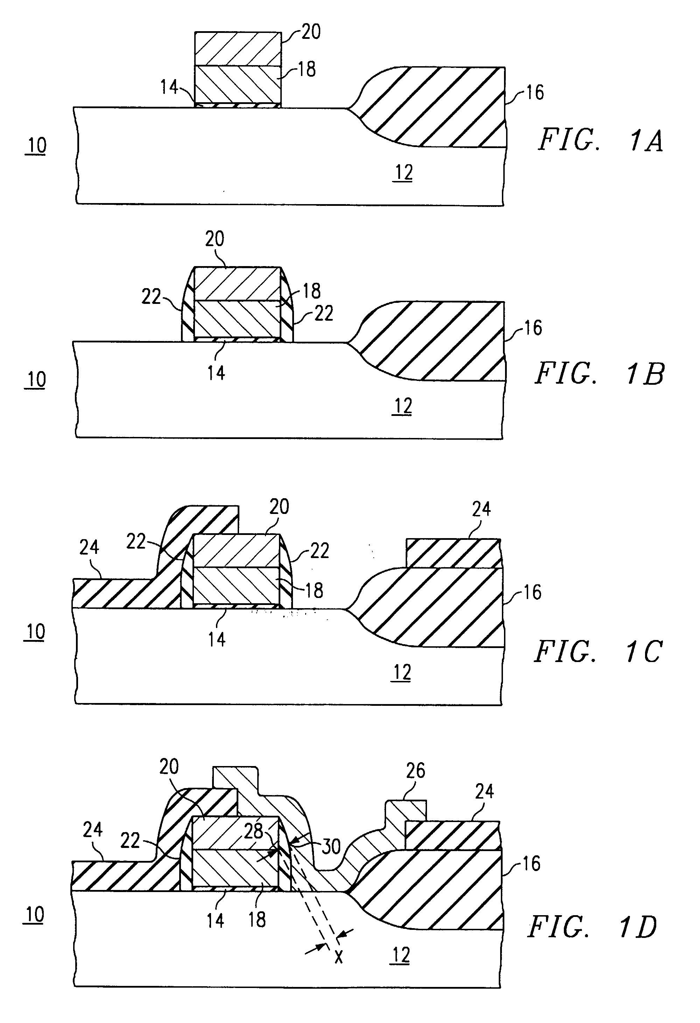

With reference specifically to Fig. 1B, at this point, spacer layers 22 are formed overlying the sidewalls of the gate oxide 14, the gate 18 and the overgate layer 20 as shown. The spacer layers 22 may also be formed of SiO₂ or Si₃N₄ and taper from the substrate 12 toward the upper surface of the overgate layer 20 substantially as shown.

With reference specifically to Fig. 1C as well, at this point in the process for forming the prior art self-aligned contact 10, an interpoly oxide layer 24 is formed and patterned substantially as shown such that at least a portion of the substrate 12, one of the spacer layers 22 and a portion of the overgate layer 20 is covered thereby. In addition, the interpoly oxide layer 24 is also formed overlying the upper surface of the field oxide region 16.

With reference specifically to Fig. 1D also, it is at this point that a local interconnect 26 formed of polysilicon or polysilicide ("poly 2") is deposited overlying the remaining portion of the overgate layer 20 and a portion of the interpoly oxide layer 24 also overlying the overgate layer 20 and extending over one of the spacer layers 22, the upper surface of the substrate 12, a portion of the field oxide region 16 and a portion of the interpoly oxide layer 24 overlying the field oxide region 16.

As indicated, the local interconnect 26 is then spaced apart from the gate 18 by a minimum distance "x" indicated taken at the upper corner 28 of the gate 18 and a nearest point 30 on the local interconnect 26. The distance "x" in prior art self-aligned contacts 10 has been found to vary substantially between 100Å to 400Å.

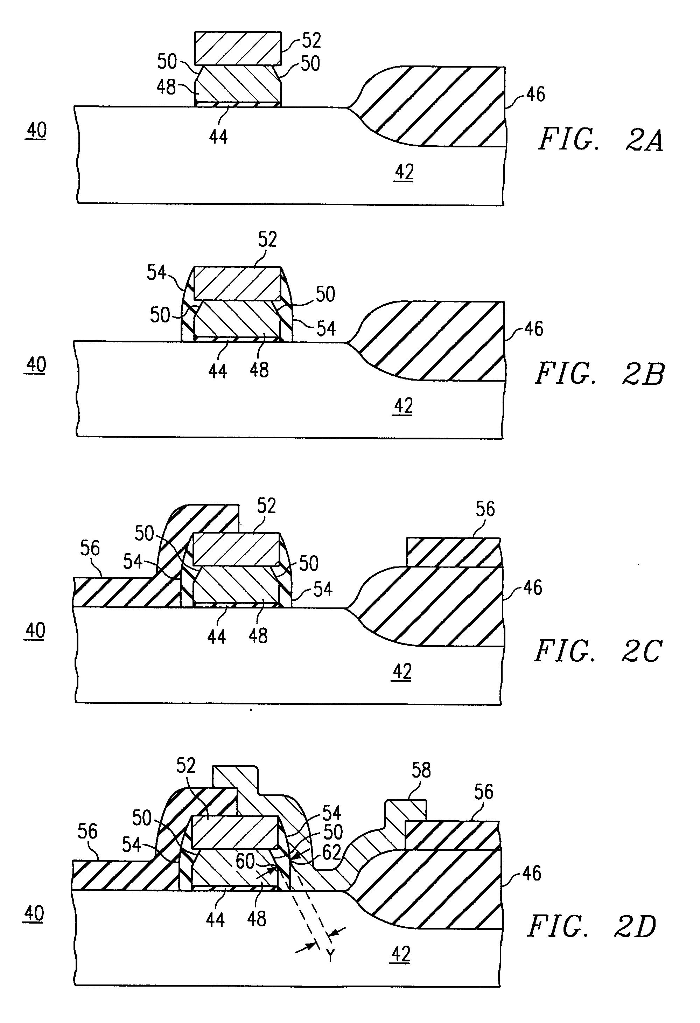

With reference now to Figs. 2A through 2D a self-aligned contact 40 in accordance with the present invention is shown. With specific reference to Fig. 2A, the process begins with the provision of a suitable semiconductor substrate 42 upon which have been formed a relatively thin gate oxide layer 44 and a relatively thick field oxide region 46. A well and isolation formation step is also performed at this time.

A gate 48 presenting beveled surfaces 50 non-orthogonal to the substrate 42 major surface (which may be formed in the sidewalls adjoining the upper surface thereof as described hereinafter) is then formed overlying the gate oxide layer 44 as part of a doped first polysilicon or polysilicide deposition step which is formed to a thickness of substantially between 1500Å - 2000Å. The gate 48 is conveniently referred to as a "poly 1" layer. An overgate layer 52 of silicon dioxide (SiO₂), silicon nitride (Si₃N₄) of other dielectric material is then deposited overlying the gate 48 upper surface.

At this point the poly 1 pattern and etching operations take place. The first etch step is to perform an anisotropic dry etch to remove the overgate oxide (or Si₃N₄) layer 52 followed by a two step etch operation to form the beveled surfaces 50 in the sidewalls of the gate 48. The beveled surfaces 50 may be formed by an initial isotropic (or "wet") etch to produce the beveled surfaces 50 adjacent the upper surface of the gate 48 followed by an anisotropic (or "dry") etch to form the substantially vertical sidewalls of the gate 48.

With reference specifically to Fig. 2B, at this point, spacer layers 54 are formed overlying the sidewalls of the gate oxide 44, the beveled surfaces 50 and sidewalls of the gate 48 and the overgate layer 52 as shown in conjunction with the formation of active devices and source/drain implant operations elsewhere on the semiconductor substrate 42. The spacer layers 54 may also be formed of SiO₂ or Si₃N₄ and taper from the substrate 42 upper surface toward the upper surface of the overgate layer 52 substantially as shown.

With reference specifically to Fig. 2C as well, at this point in the process for forming the self-aligned contact 40, an interpoly oxide layer 56 is deposited and patterned substantially as shown to a thickness of substantially between 1000Å - 2000Å such that at least a portion of the substrate 42, one of the spacer layers 54 and a portion of the overgate layer 52 is covered thereby. The interpoly oxide layer 56 may be formed of SiO₂ or other suitable insulating material. In addition, the interpoly oxide layer 56 is also formed overlying the upper surface of the field oxide region 46. This operation is followed by a self-aligned contact 40 patterning and etch operation to produce the interpoly oxide layer 56 shown.

With reference specifically to Fig. 2D also, it is at this point that a local interconnect 58 formed of polysilicon or polysilicide ("poly 2") is deposited to a thickness of substantially between 500Å - 2000Å overlying the remaining portion of the overgate layer 52 and a portion of the interpoly oxide layer 56 also overlying the overgate layer 52 and extending over one of the spacer layers 54, the upper surface of the substrate 42, a portion of the field oxide region 46 and a portion of the interpoly oxide layer 56 overlying the field oxide region 46. This is followed by a local interconnect 58 patterning and etching operation and other multi-poly processing steps as may be desired.

As indicated, the local interconnect 58 is then spaced apart from the gate 48 beveled surfaces 50 by a minimum distance "y" indicated taken at a sidewall conformality corner 60 formed at the interface between the sidewall and beveled surfaces 50 of the gate 48 and a nearest point 62 on the local interconnect 58. The distance "y" in a self-aligned contact 40 in accordance with the present invention has been found to vary substantially between 500Å to 1000Å.

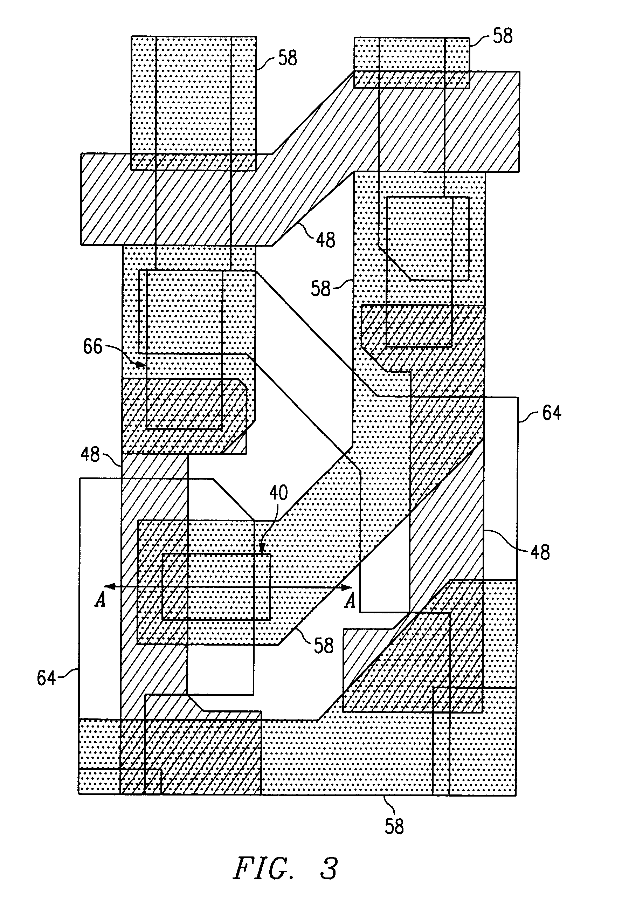

With reference now to Fig. 3, a top-plan view of a cell layout for a portion of an exemplary integrated circuit device manufactured in accordance with the process sequence of Figs. 2A through 2D is shown. The cell layout illustrated shows a portion of an SRAM cell incorporating the self-aligned contact 40 of Figs. 2A through 2D, the cross-sectional view shown in the preceding figures having been taken substantially along section line A-A illustrated.

The poly 1 layer comprising gate 48 is herein illustrated by those portions enclosing a single diagonal cross-hatching while the poly 2 layer comprising local interconnect 58 is shown by those portions enclosing a crisscross cross-hatching resembling a number of diagonally disposed squares. The integrated circuit device active region 64 is shown as those portions enclosing a number of dots. A poly 1 to poly 2 contact 66 is also illustrated.

What has been provided, therefore, is a self-aligned contact for a semiconductor integrated circuit device which improves the isolation between the poly 1 and poly 2 layers while concomitantly providing an enhanced poly 1 to poly 2 contact area in other regions of the integrated circuit. The technique herein disclosed further serves to reduce the contact aspect ratio through a reduction in the thickness of the overgate oxide and interpoly oxide layers overlying the gate and no contact to the gate enclosure is required.

While there have been described above the principles of the present invention in conjunction with specific processes, materials and device structures it is to be clearly understood that the foregoing description is made only by way of example and not as a limitation to the scope of the invention. Particularly, it is recognized that the teachings of the foregoing disclosure will suggest other modifications to those persons skilled in the relevant art. Such modifications may involve other features which are already known per se and which may be used instead of or in addition to features already described herein. Although claims have been formulated in this application to particular combinations of features, it should be understood that the scope of the disclosure herein also includes any novel feature or any novel combination of features disclosed either explicitly or implicitly or any generalization or modification thereof which would be apparent to persons skilled in the relevant art, whether or not such relates to the same invention as presently claimed in any claim and whether or not it mitigates any or all of the same technical problems as confronted by the present invention. The applicants hereby reserve the right to formulate new claims to such features and/or combinations of such features during the prosecution of the present application or of any further application derived therefrom.

## Claims

1. An integrated circuit device formed on a semiconductor substrate having a major surface thereof, said device comprising:
at least one contact formed on a gate oxide layer overlying said major surface of said substrate, said contact comprising a doped semiconductor material formed to present at least one surface non-orthogonal to said substrate in a sidewall thereof;
an insulating layer overlying said gate region;
a spacer layer adjoining said insulating layer and substantially surrounding said contact sidewall and said non-orthogonal surface; and
a local interconnect layer overlying said spacer layer and at least a portion of said insulating layer.

2. The integrated circuit device of claim 1 wherein said doped semiconductor material comprises either polysilicon or polysilicide.

3. The integrated circuit device of claim 1 or 2 wherein said insulating layer comprises an overgate layer and an interpoly oxide layer.

4. The integrated circuit device of claim 3 wherein said interpoly oxide layer comprises Si0₂.

5. The integrated circuit device of claim 3 wherein said overgate layer comprises either Si0₂ or Si₃N₄.

6. The integrated circuit device of any preceding claim wherein said spacer layer comprises either Si0₂ or Si₃N₄.

7. The integrated circuit device of any preceding claim wherein said local interconnect layer comprises either polysilicon or polysilicide.

8. A process for forming an integrated circuit comprising the steps of:
providing a substrate, said substrate presenting a major surface thereof;
forming a contact on a gate oxide layer overlying said major surface of said substrate;
overlying said gate region with an insulating layer;
etching said contact and said overgate layer to produce at least one surface in a sidewall of said contact non-orthogonal to said substrate;
also forming at least one spacer layer adjoining said overgate layer and substantially surrounding said at least one non-orthogonal surface and said sidewall; and
depositing a local interconnect layer overlying said spacer layer and at least a portion of said overgate layer.

9. The process of claim 8 wherein said step of forming is carried out by the step of depositing either polysilicon or polysilicide on said gate oxide layer.

10. The process of claim 8 or 9 wherein said step of overlying is carried out by the steps of:
firstly depositing an overgate layer on said contact; and
secondly depositing an interpoly oxide layer at least partially overlying said overgate layer.

11. The process of claim 10 wherein said step of firstly depositing is carried out by the step of:
depositing either Si0₂ or Si₃N₄ to a thickness of substantially between 1000Å to 2000Å.

12. The process of claim 10 or 11 wherein said interpoly oxide layer is substantially between 1000Å to 2000Å in thickness.

13. The process of any of claims 8 to 12 wherein said step of etching is carried out by the steps of:
isotropically etching said contact to produce said at least one non-orthogonal surface in said sidewall; and
anisotropically etching said contact to provide a substantially vertical profile to said sidewall adjoining said non-orthogonal surface.

14. The process of any of claims 8 to 13 wherein said step of also forming is carried out by the step of:
depositing either Si0₂ or Si₃N₄.
